# EUROPEAN PATENT APPLICATION

(11) **EP 4 391 087 A1**
(43) Date of publication of application: **26.06.2024**
(21) Application number: 22306957.6
(22) Date of filing: 20.12.2022
(51) Int. Cl.: H01L 31/0687, H01L 31/0747, H01L 31/076, H10K 30/00

(54) **HOLE-SELECTIVE CONTACT STRUCTURE FOR SOLAR CELL**

(71) Applicant: COMMISSARIAT À L'ÉNERGIE ATOMIQUE ET AUX ÉNERGIES ALTERNATIVES, 75015 Paris (FR); Universitat Politècnica de Catalunya, 08034 Barcelona (ES)
(72) Inventor: MUNOZ, Maria-Delfina, 38054 Grenoble cedex 09 (FR); MASMITJA RUSIÑOL, Gerard, 38054 Grenoble cedex 09 (FR)
(74) Representative: Germain Maureau

(57) **Abstract**

A multilayer structure (100) for photovoltaic applications, the multilayer structure (100) comprising:
- a n-type high-work function transition metal oxide (TMO) layer (3) deposited on a support structure (6),
- a thin n-type low-work function transition metal oxide (TMO) layer (2) covering the n-type high-work function TMO layer (3), and
- a first absorber cell (1) based on a perovskite material on the n-type low-work function TMO layer (2),
the n-type high-work function TMO layer (3) and the thin n-type low-work function TMO layer (2) forming a hole-selective contact structure (200).

## Description

The present invention belongs to the field of photovoltaics and in particular, to the field of perovskite based solar cell. In one aspect, the invention is a novel multilayer structure comprising a hole-selective contact structure for single solar cells as well as for monolithic tandem solar cells. In another aspect, the invention is a method for manufacturing the said multilayer structure for application in single or tandem cells.

Crystalline silicon (c-Si) single junction solar cells are reaching their limit in energy conversion efficiency. Moreover, the selective contact for the silicon cell is commonly made by doping a Si film and a drawback of this approach is that the highly doped Si based films have a non-negligible light absorption coefficient.

Solar cells with a perovskite absorber layer have so far exceeded efficiencies of over 25%. In order to avoid the used of selective contact layers which are light absorbent, the use of n-type high work function TMO (Transition Metal Oxide) has been investigated. But theseTMOs layers are unstable when exposed to air, e.g. its passivation properties in c-Si substrates degrade after a few hours, even minutes.

At the same time, the use of tandem devices is attracting interest to overcome the physical limitation of silicon and get photovoltaic conversions efficiencies above 26%. Due to the optically tunable band gap, potentially low cost manufacturing processes, and high efficiencies, perovskite absorber layers are the ideal partner for tandem integration as the top sub-cell (i.e. the light-facing partial solar cell in the tandem solar cell) with bottom sub-cells made of various materials including silicon. Nevertheless, the contact layers or the interface layers in tandem junctions are usually made of materials with a significant light absorption coefficient.

There is a need to provide new contact layers and/or interface layers that are less optically absorbent. It is thus an object of the present invention to find a solution that alleviates at least the aforementioned drawback. To this end, the present invention provides a multilayer structure for photovoltaic applications, the multilayer structure comprising:
- a n-type high-work function transition metal oxide (TMO) layer deposited on a support structure,
- a thin n-type low-work function transition metal oxide (TMO) layer covering the n-type high-work function TMO layer, and
- a first absorber cell based on a perovskite material, on the n-type low-work TMO layer,
the n-type high-work function TMO layer and the thin n-type low-work function TMO layer forming a hole-selective contact structure.

In this configuration, the n-type high-work function transition metal oxide layer (TMO) is able to form a hole transport layer (HTL) from the perovskite absorber layer and it was found that the thin n-type low-work function transition metal oxide layer is able to prevent the instability of the HTL by offering an efficient capping effect. The n-type low-work function TMO layer being almost optically transparent as well as the n-type high-work function TMO layer, the multilayer structure is able to form a stable and efficient single-junction device in PIN configuration.

Moreover, the thinness of the low-work function TMO layer prevents the formation of a Schottky barrier. This capping layer thus guarantees the tunneling phenomena that ensures that the high-work function TMO layer can efficiently collect the holes of the first absorber cell.

According to a possibility, the perovskite material is made of CH₃NH₃PbI₃ which exhibits convenient alignment with high-work function TMOs for hole-selective contacts.

According to another embodiment, the support structure comprises a second absorber cell based on a material with a lower band gap than the material of first absorber cell so that to obtain a monolithic tandem structure. In this configuration, the hole-selective contact structure is formed on the second absorber cell. Thus, the multilayer structure is also adapted to the manufacture of a monolithic tandem solar cell, the first absorber cell being the top sub-cell that first receives sunlight and the second absorber cell being the bottom sub-cell.

The second absorber cell is chosen among a Silicon-based cell, (e.g. HeteroJunction cell SHJ, a TOPCon cell or a POLO cell), an Organic material cell, a Perovskite cell or a combination of at least two of these cells.

According to a possibility, the second absorber cell comprises a second absorber layer of c-Si material, a second passivation layer of (i) a-Si:H and a n-type doped Si layer, which is covered by the hole-selective contact structure so that the n-type doped Si layer and the hole-selective contact structure form a recombination junction.

In this configuration, the n-type doped Si layer contains a P dopant concentration between 2×10²⁰ and 4×10²⁰ at.cm⁻³ so that to prevent a high band bending in contact with the high-work function TMO layer which would introduce a Schottky barrier for the electrons.

The n-type high-work function TMO layer is thus part of the recombination junction replacing the conventional p-doped Si layer in the tunnel junction or the ITO layer. The HTL structure applied in such tandem configuration minimizes the use of light-absorbing films, such as doped silicon layers, and avoids the use of ITO containing indium that suffers of price volatility.

According to a possibility, the material of the n-type high-work function TMO layer is chosen among MoOx, VOx, WOx and a combination of at least two of these materials.

The n-type high-work function TMO layer has a work function of at least 5 eV. This allows the use of this layer as a HTL layer.

Moreover, the n-type high-work function TMO layer has a band gap of at least 3 eV. This ensures that the layer is optically transparent to the absorbed wavelengths of the absorber cell (almost no light absorption).

Advantageously, the n-type high-work function TMO layer is deposited by a highly conformal film deposition technique such as ALD (Atomic Layer Deposition), up to a thickness between 4 and 11 nm, that offers a low-temperature processing. This thickness allows the layer to provide an efficient HTL effect, a low roughness layer, and pinhole-free conformal thin films.

According to a variant, the n-type high-work function TMO layer is deposited by a coarse deposition technique such as thermal deposition or sputtering, up to a thickness between 20 and 50 nm, in order to provide same properties as those of the TMO deposited by ALD.

According to a possibility, the material of the thin n-type low-work function TMO layer is chosen among ZnO, TiOx and combination of at least two of these materials.

The n-type low-work function TMO layer has a work function strictly less than 4.5 eV in order to form an efficient capping effect.

The n-type low-work function TMO layer has a band gap of at least 3 eV in order to be optically transparent to the absorbed wavelengths.

According to a variant, the material of the thin n-type low-work function TMO layer is n-type doped, such as Al-doped ZnO, in which the dopant concentration is strictly less than 10²⁰ at.cm⁻³. This dopant concentration guarantees that the perovskite absorber layer is affected by the high-work function of the TMO-based HTL.

According to a possibility, the thin n-type low-work function TMO layer has a thickness between 0,5 nm and 2,5 nm. This thickness guarantees the tunneling phenomena so that the hole-selective contact structure can efficiently collect the holes of the perovskite absorber layer.

According to an embodiment, the multilayer structure comprises a passivation and wetting agent film underlying the perovskite absorber layer of the first absorber cell, such as a PFN monolayer, a SAM layer or a layer of dipole, such as a branched polyethylenimine also called b-PEI, a MeO-2PACz (or 2-(3,6-dimethoxy-9H-carbazol-9-yl)ethyl]phosphonic acid) and a Poly-TPD (poly[N,N'-bis(4-butylphenyl)-N,N'-bis(phenyl)benzidine]). The thickness of this passivation layer is around 2 nm. This layer is deposited on the n-type low-work function TMO layer and assists the growth of the perovskite layer.

Various other embodiments of the invention may include the following:
- The support structure comprises a substrate, chosen for example among glass, polymer, and metal foils.
- The support structure comprises an electron selective contact (ETL), for example a SnO2 layer.
- The support structure comprises a conductive film such as TCO, metal and TCO/metal.
- The first absorber cell made of perovskite material is covered by an electron selective contact layer, such as a SnO2 layer, and a conductive film, for example a TCO, a metal or a TCO/Metal film.
- The second absorber layer of c-Si material lays on a passivation layer of (i) a-Si:H deposited on a (p) a- Si:H layer, and an ITO layer forms the conductive layer.
- The n-type high-work function TMO layer is deposited directly on the n-type Si-based film of which content of dopant is strictly greater than 10²⁰ at.cm⁻³.

In another aspect, the invention concerns a method for manufacturing a multilayer structure for a photovoltaic application, the method comprising the steps of:
- providing a support structure,
- depositing a n-type high-work function transition metal oxide (TMO) layer,
- depositing a thin n-type low-work function transition metal oxide layer covering the n-type high-work function TMO layer,
- growing a first absorber cell based on a perovskite material on the n-type low-work function TMO layer,
the n-type high-work function transition metal oxide (TMO) layer and the thin n-type low-work function transition metal oxide layer forming a hole-selective contact structure.

In particular, the n-type high-work function TMO layer is deposited by ALD up to a thickness of about 7 nm. The n-type high-work function TMO layer may comprise a V₂O₅ material.

According to an embodiment, the thin n-type low-work function TMO layer is deposited by ALD up to a thickness of about 2,5 nm. The n-type low-work function TMO layer may comprise a ZnO material.

Advantageously, the n-type high-work function TMO layer and thin n-type low-work function TMO layer are deposited one after the other inside the same chamber. This avoids to break the vacuum between the two steps.

According to a variant, the method comprises an additional step before the growth of the perovskite layer, the additional step comprising the deposition of a passivation and wetting agent film on the n-type low-work function TMO layer in order to improve the TMO selectivity and the perovskite wettability. The passivation and wetting agent film is chosen among PFN monolayer, a SAM and a dipole layer.

The n-type high-work function of some TMOs can to be deposited by different techniques, such as thermal evaporation, atomic layer deposition (ALD), spatial ALD or sputtering, which allows them to be used in different surface topology, like textured or polished.

With reference to the appended drawings, below follows a more detailed description of aspects of the invention cited as examples.
Figure 1 illustrates a multilayer structure for application in the field of photovoltaics according to one embodiment of the invention.
Figure 2 illustrates an application of the multilayer structure in a single junction solar cell according to an embodiment of the invention.
Figure 3 illustrates a band diagram of a single junction solar cell comprising the multilayer structure of figure 1.
Figure 4 illustrates an application of the multilayer structure in a monolithic tandem junction solar cell according to a variant embodiment of the invention.
Figure 5 illustrates a band diagram of the tandem junction solar cell solar cell comprising the multilayer structure of figure 4.

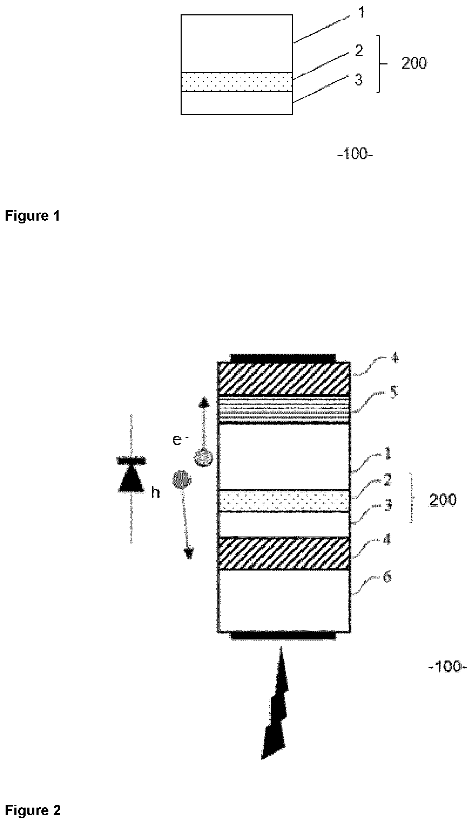

With reference to figure 1 is shown a part of a multilayer structure 100 of the invention. The structure 100 comprises a first absorber cell 1 based on a perovskite material that lays on a hole-selective contact structure comprising a thin n-type low-work function transition metal oxide (TMO) layer 2 of ZnO and a n-type high-work function transition metal oxide layer 3 of V₂O₅ on a support structure 6 (not shown). The n-type high-work function TMO layer 3 forms a hole-selective layer and the thin n-type low-work function TMO layer 2 is a capping layer that prevents the degradation of the n-type high-work function TMO layer 3. The thin capping layer 2 has a sufficiently low thickness to avoid the formation of a Schottky barrier for electron. As shown in the figure 1, the thickness of the capping layer 2 is 2,5 nm whereas the hole selective layer 3 has a thickness of 7 nm when deposited by an ALD method.

In another embodiment, the capping layer 2 has a recommended thickness comprised between 0,5 nm and 2,5 nm as the layer 2 needs to be thin enough to ensure tunneling phenomena.

This capping layer 2 can also be n-type doped, such as aluminum doped ZnO (AZO). In these cases, the dopant concentration must be weak (<10²⁰ at.cm⁻³) to guarantee that the perovskite absorber layer 1 is affected by the n-type high-work function of the TMO-based HTL3.

Not shown in the figures, the hole-selective layers 3 must be thick enough to ensure good performance as HTL. Thus, a thickness between 5 and 10 nm is recommended in case that a highly conformal film deposition technique, such as ALD, is used. In addition, a thicker layer 3, between 20 and 50 nm is recommended in case of a use of a coarse deposition technique, such as thermal evaporation or sputtering.

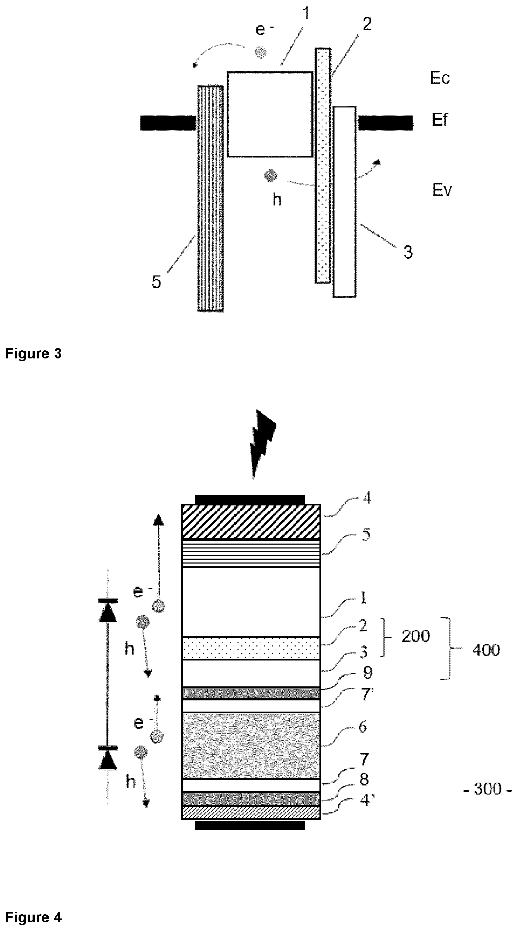

As illustrated in figures 2 and 3, the multilayer structure 100 is used to form a single-junction solar cell with a PIN configuration. The perovskite absorber layer 1 is grown on a glass substrate 6 which is covered with a conductive film 4 such as a Transparent Conductive Oxide (TCO) and the hole-selective contact structure 200. Note that the support structure topology can vary without the need to modify the hole-selective contact structure 200. The n-type high-work function TMO layer 3 and the n-type low-work function TMO layer 2 are deposited by ALD one after the other, without breaking the vacuum. Then, the perovskite absorber layer 1 is grown and the cell is finished with an ETL (Electron Transport Layer) contact structure made of an electron selective contact layer 5 in SnO₂ and a conductive film 4. Note that the hole-selective contact structure 200 is not altered by the composition of the ETL contact structure 5, 4. The band diagram of the solar cell of figure 3 shown the transfers of the electrons and the holes from the perovskite absorber layer 1 when photons are absorbed.

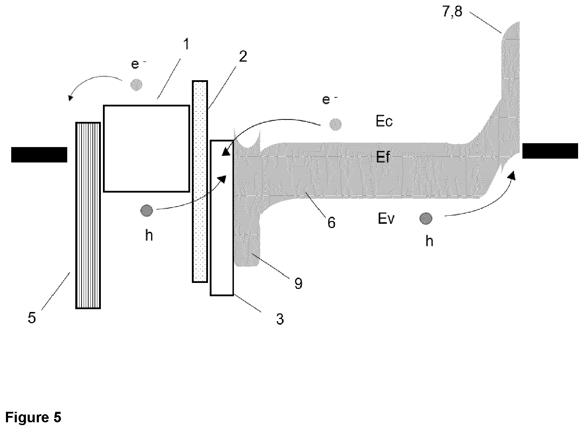

With reference to figures 4 and 5, a variant of the present invention is shown wherein the multilayer structure is a monolithic tandem junction solar cell 300. This monolithic tandem device 300 uses a heterojunction structure based on silicon (SHJ cell) as the support structure 6, a recombination junction based on doped silicon layer and a first absorber cell in a PIN configuration. The heterojunction structure comprises a second absorber cell comprising a second absorber layer 6 of c-Si laying on a passivation layer 7 of (i) a-Si:H which is itself deposited on a (p) a-Si:H layer 8. An ITO layer 4' forming the conductive film is the last bottom layer. In this configuration, the first absorber cell 1 is a top sub-cell and the second absorber cell 6 is the bottom sub-cell of the tandem device 300.

On top of the second absorber layer 6 of c-Si is a second passivation layer 7' of (i) a-Si:H followed by a (n) nc- Si:H layer 9. The dopant concentration in the n-doped nc-Si:H layer 9 is around 3×10²⁰ at/cm⁻³ such that the hole-selective contact structure 200 can be deposited directly on it. This doping indeed prevents a high band bending in contact with the n- type high-work function TMO layer 3, which would introduce a Schottky barrier for the electrons. This configuration allows to avoid the conventional (p) doped Silicon layer that forms part of the conventional recombination junction when combined with the (n) nc- Si:H layer 9. Thus, the hole-selective contact structure 200 collects the holes of the Perovskite absorber layer 1 and is part of the recombination junction 400 with the n-type doped Si-based layer 9, e.g. V₂O₅/nc-Si(n) junction 400.

As shown on the figure 4, the perovskite /c-Si tandem scheme using these TMOs can avoid the use of ITO (Indium Transparent Oxide) film between the n- type high-work function TMO layer 3 and the n-type doped Si-based layer 9 e.g. V₂O₅/ITO/nc-Si(n) junction.

According to another variant not shown on the figures, the monolithic tandem device 300 comprises a second absorber cell that may be either TOPCon, a POLO, or an organic material such as PM₆:Y₆-based or PTB₇-Th:O₆T-4F-based bulk-heterojunction organic or a perovskite absorber layer 6, such as FA_{0.83}Cs_{0.17}Pb(I _{0.5}Br_{0.5})₃ having a 1.8 eV bandgap that is ideally suited for the 2T tandem (the bandgap is controlled by tuning the Br:l ratio), of which the band gap is lower than the one of the first absorber cell. (PTB7-Th is available from 1-Material Inc.^{®}, PM6 is available from Solarmer Inc.^{®} Y6 and O6T-4F are available from Shenzhen Ruixun Inc.^{®})

Figure 5 illustrates the band diagram of the above-depicted tandem device 300 showing the electrons of the perovskite absorber layer 1 (top sub-cell) that are transferred in the ETL and the holes transferred in the hole selective contact structure 200 upon irradiation. The electrons of the bottom sub-cell are also transferred in the recombination junction 400 where there are recombined with the transferred holes from the top sub-cell. The band diagram shows that the hole transport layer of the absorber (film 1) is formed by a hole selective contact layer 3 coated with a thin n-doped low-work function TMO layer 2. It also shows the formation of a recombination junction between the hole selective contact layer 3 and the (n) nc-Si:H layer 9.

Thus, the multilayer structure 100, (single-junction solar cell or monolithic tandem structure 300) according to the present invention allows the use of a hole selective contact layer 3 that are optically transparent. This layer 3 is made of an n-doped high-work function TMO such as VOx, MoOx, WOx that has a high band gap. A thin n-doped low-work function TMO layer 2 which is also optically transparent forms a capping layer that guarantees the stability of the hole selective contact layer 3 and also a tunneling phenomena in order to provide efficient solar absorption. In addition, the hole selective contact structure 200 (layers 2 and 3) is also useful for a monolithic tandem junction solar cell 300 in which the n-doped high-work function TMO layer 3 is able to be part of the recombination junction 400 when combined with a sufficiently n-doped silicon layer 9. The n-doped high-work function TMO layer 3 is also capable of replacing an ITO layer between the two absorber sub-cells.

## Claims

1. A multilayer structure (100) for photovoltaic applications, the multilayer structure (100) comprising:
- a n-type high-work function transition metal oxide (TMO) layer (3) deposited on a support structure (6),
- a thin n-type low-work function transition metal oxide(TMO) layer (2) covering the n-type high-work function TMO layer (3), and
- a first absorber cell (1) based on a perovskite material on the n-type low-work function TMO layer (2),
the n-type high-work function TMO layer (3) and the thin n-type low-work function TMO layer (2) forming a hole-selective contact structure (200).

2. A multilayer structure (100) according to claim 1, wherein the support structure (6) comprises a second absorber cell based on a material with a lower band gap material than the material of the first absorber cell (1) so that to obtain a monolithic tandem structure (300).

3. A multilayer structure (100) according to claim 2, wherein the second absorber cell comprises a second absorber layer (6) of c-Si, a second passivation layer (7') of (i) a-Si:H and a n-type doped Si layer (9) , which is covered by the hole-selective contact structure (200) so that n-type doped Si layer (9) and the hole-selective contact structure (200) form a recombination junction (400).

4. A multilayer structure (100) according to one of claims 1 to 3, wherein the material of the n-type high-work function transition metal oxide layer (3) is chosen among MoOx, VOx, WOx and a combination of at least two of these materials.

5. A multilayer structure (100) according to one of claims 1 to 4, wherein the n-type high-work function transition metal oxide layer (3) deposited by a highly conformal film deposition technique such as ALD (atomic layer deposition), up to a thickness between 4 and 11 nm.

6. A multilayer structure (100) according to one of claims 1 to 4, wherein the n-type high-work function transition metal oxide layer (3) deposited by a coarse deposition technique such as thermal deposition or sputtering, up to a thickness between 20 and 50 nm.

7. A multilayer structure (100) according to one of claims 1 to 6, wherein the material of the thin n-type low-work function transition metal oxide layer (2) is chosen among ZnO, TiOx and combination of at least two of these materials.

8. A multilayer structure (100) according to one of claims 1 to 6, wherein the material of the thin n-type low-work function transition metal oxide layer (2) is n-type doped, such as Al-doped ZnO in which the dopant concentration is strictly less than 10²⁰ at.cm⁻³.

9. A multilayer structure (100) according to one of claims 1 to 8, wherein the thin n-type low-work function transition metal oxide layer (2) has a thickness between 0,5 nm and 2,5 nm.

10. A multilayer structure (100) according to one of claims 1 to 9, comprising a passivation and wetting agent film underlying a perovskite absorber layer (1) of the first absorber cell, such as a PFN monolayer, a SAM layer or a layer of dipole.

11. Method for manufacturing a multilayer structure (100) for a photovoltaic application, the method comprising the steps of:
- providing a support structure (6),
- depositing a n-type high-work function transition metal oxide (TMO) layer (3),
- depositing a thin n-type low-work function transition metal oxide layer (2) covering the n-type high-work function TMO layer (3),
- growing a first absorber cell based on a perovskite material (1) on the n-type low-work function TMO layer (2),
the n-type high-work function transition metal oxide layer (3) and the thin n-type low-work function transition metal oxide layer (2) forming a hole-selective contact structure (200).

12. Method for manufacturing a multilayer structure (100) according to claim 11, wherein the n-type high-work function TMO layer (3) is deposited by ALD up to a thickness of about 7 nm.

13. Method for manufacturing a multilayer structure (100) according to claim 11 or 12, wherein the thin n-type low-work function TMO layer (2) is deposited by ALD up to a thickness of about 2,5 nm.

14. Method for manufacturing a multilayer structure (100) according to claim 13 wherein the n-type high-work function TMO layer (3) and thin n-type low-work function TMO layer (2) are deposited one after the other inside the same chamber.

15. Method for manufacturing a multilayer structure (100) according to anyone of claim 11 to 14, comprising an additional step before the growth of the perovskite layer (1), the additional step comprising the deposition of a passivation and wetting agent film on the thin n-type low-work function TMO layer (2).
